# EUROPEAN PATENT SPECIFICATION

(11) **EP 2 870 497 B1**
(45) Date of publication and mention of the grant of the patent: **19.10.2016**
(21) Application number: 13739852.5
(22) Date of filing: 04.07.2013
(51) Int. Cl.: G02B 21/00, G02B 21/33, H01J 37/22, H01J 37/28

(54) **INTEGRATED LIGHT OPTICAL AND CHARGED PARTICLE BEAM INSPECTION APPARATUS**
INTEGRIERTES INSPEKTIONSSYSTEM MIT LICHT- UND TEILCHENOPTISCHER ABBILDUNG
SYSTEME D'INSPECTION INTEGREE AVEC OPTIQUE DE LUMIERE ET OPTIQUE DE PARTICULES

(30) Priority: 04.07.2012 NL 1039714; 27.03.2013 NL 1040131
(43) Date of publication of application: 13.05.2015
(73) Proprietor: Delmic B.V., 2629 JD Delft (NL)
(72) Inventor: HOOGENBOOM, Jacob Pieter, NL-2628 CN Delft (NL); ZONNEVYLLE, Aernout Christiaan, NL-2628 CN Delft (NL)
(74) Representative: Peters, Sebastian Martinus
(86) International application number: PCT/NL2013/050492
(87) International publication number: WO 2014/007624

(56) References cited:
- EP-A1- 2 388 575
- EP-A2- 1 998 207
- EP-A2- 2 061 067
- WO-A2-2012/008836
- NISHIYAMA H ET AL: "Atmospheric scanning electron microscope observes cells and tissues in open medium through silicon nitride film", JOURNAL OF STRUCTURAL BIOLOGY, ACADEMIC PRESS, UNITED STATES, vol. 169, no. 3, 1 March 2010 (2010-03-01) , pages 438-449, XP026913027, ISSN: 1047-8477, DOI: 10.1016/J.JSB.2010.01.005 [retrieved on 2010-01-15]
- A.C. ZONNEVYLLE ET AL: "Integration of a high-NA light microscope in a scanning electron microscope", JOURNAL OF MICROSCOPY, 25 July 2013 (2013-07-25), pages n/a-n/a, XP055079052, ISSN: 0022-2720, DOI: 10.1111/jmi.12071

## Description

### BACKGROUND OF THE INVENTION

### 1. Field of the Invention

The present invention relates to an improvement in a so-called integrated inspection apparatus, featuring the integration of a scanning electron microscope (SEM) and light microscope optics. The improvement in particular relates to improvement of the quality and practical usability of the optical part of the apparatus.

In this respect, it is noted that information obtained from images with light microscopy and electron microscopy is to a large extent complementary. With a light microscope different objects can be seen and inspected in a specimen in different colors, which allows for identification of part or whole of the composition of this specimen. Instead of directly observing color from a constituent of the specimen, prior art systems very often attach specific color markers such as fluorophores or autofluorescent proteins to a specific non-colored constituent for identification.

With an electron microscope, all constituents of a specimen can be imaged at very small detail (high resolution), much smaller than with a light microscope, but the ability to identify constituents based on color is absent. In correlative light-electron microscopy, therefore, users try to obtain images from the same area of a specimen, the so called Region of Interest or ROI for short, with both the light and the electron microscope. A very accurate and quick way of doing this, is by using an integrated microscope wherein both types of microscope or parts thereof are to a more or less integrated extent contained in a single apparatus.

### 2. Description of the Related Art

Such an integrated system is known in the art, e.g. from the short technical note "Specimen stage incorporating light microscopical optics for a Cambridge S180 scanning electron microscope" by Wouters et al in J. of Microscopy Vol. 145, Feb. 1987, pages 237-240. Recent improvements of that principle are provided by Applicant in patent publication WO2012008836 and is in line with the present invention generally described as an inspection apparatus provided with an optical microscope and an ion- or electron microscope, equipped with a source for emitting a primary beam of radiation to a sample in a sample holder. The apparatus comprises a detector for detection of secondary radiation backscattered from the sample and induced by the primary beam. The optical microscope is equipped with a light collecting and recording device such as a CCD camera or other light recording device, to receive in use luminescence light emitted by the sample. Typical prior art systems that may be found in the market are the JEOL ClairScope ™ apparatus, a so called Shuttle&Find ™ apparatus or any other known apparatus for dual manner of sample inspection, as well as the apparatus by Applicant as published by publication of the international patent application WO2012008836. A similar apparatus is disclosed in EP2 388 575.

In general, with the systems under consideration, it is to be remarked that information obtained from images with light microscopy and electron microscopy is to a large extent complementary. With a light microscope different objects can be seen in a specimen in different colors. This allows for identification of the composition, at least parts thereof, of this specimen. Instead of directly observing color from a constituent of the specimen, very often specific color markers, such as fluorophores or autofluorescent proteins, are attached to a specific non-colored constituent for identification.

With an electron microscope, all constituents of a specimen can be imaged at very small detail, much smaller than with a light microscope, but the ability to identify constituents based on color is lacking. Therefore, people very often try to obtain images from the same area of a specimen with both light and electron microscopy. A very accurate and quick way of doing this, is by using an integrated microscope wherein at least parts of both microscopes are contained in one apparatus.

In an integrated light-electron microscope, a problem may arise due to the need for a vacuum in the electron microscope. It is highly desirable for an integrated light-electron microscope to have at least the objective lens of the light microscope in the vacuum chamber close to the specimen holder and the electron lens. The vacuum in between objective lens and specimen, or between objective lens and the microscope slide that supports the specimen, leads to unwanted refraction of light at the specimen-vacuum interface. This in turn leads to a loss of light collected by the objective, a loss of resolution, and an increase of errors in the image.

In conventional microscopes, this problem also occurs with air in between objective lens and specimen. A well-known solution to this problem is the use of an immersion liquid between objective and specimen, where the immersion liquid has a refractive index matched to the refractive index of objective lens and specimen and/or the microscope slide. Commercial immersion liquids exist that are tailored to have the exactly correct refractive index, to have very low light emission, and to have other characteristics beneficial for light microscopy. Manufacturers of such immersion liquids comprise amongst others Cargille, Zeiss and Leica.

For vacuum environment situations as is the case with integrated microscope apparatuses, vacuum compatible liquids have been developed, however without meeting the matching refraction index demand or other characteristics for use in light microscopy as in the case of the well known, atmospherically applicable immersion liquids. Attempts have been made to overcome this shortcoming by providing the known, well performing liquids in very thin, flexible and transparent sealings or bags, which are then positioned over the light microscope lens and in contact with the slide. However, the mere presence of such a sealing or bag with immersion liquid in turn deteriorates the normally desired refraction index.

### BRIEF SUMMARY OF THE INVENTION

With the present invention a solution is provided to the present disappointing situation on the basis of an insight and realization that in fact only a very small droplet of fluid is required between the objective lens and the slide supporting the specimen, so that so called out gassing effects will be limited. Hence, the invention, comprises the at hindsight very simple measure that a liquid is included between the objective lens of the microscope and the microscope slide, directly in between objective lens and slide. With such a measure, surprisingly, and favorably the liquid may be of none vacuum compatible origin, hence may be a known liquid for atmospheric application, having at least substantially the correct refractive index, preferably the exact correct refractive index.

As a further aspect of the present invention is that it has also been conceived to use immersion liquids optimized for light microscopy in a vacuum environment in a most favorable manner. The present invention thereto further includes that such immersion liquids optimized for use in atmospheric light microscopy are pretreated before use by subjecting these liquids to a vacuum environment. This is in particular performed in such a manner that the immersion liquids have become out gassed to a threshold level. The invention hence encompasses a method of operating an apparatus for integrated microscopy, in which in between the substrate slide and the objective lens, a liquid of optimized refractive index for light microscopy is applied directly, in which said liquid preferably has been pretreated by storing it in a vacuated or vacuous chamber until out gassing of said liquid has decreased below a certain threshold.

The invention hence explicitly includes that the liquid is provided with a refractive index larger than 1. In particular said liquid is an immersion oil for fluorescence microscopy, e.g. selected from a group of well known producers of immersion liquids for use in optical microscopy.

As a further aspect of the conception underlying the present invention, the pretreatment of the immersion liquid is performed within the vacuum chamber of the charged particle beam apparatus. On the one hand, the immersion liquid can be arranged on said objective lens inside the vacuum chamber which is or has been evacuated. The immersion liquid is exposed to the vacuum inside the vacuum chamber during a set pretreatment time, and after this pretreatment time, the immersion liquid is brought into contact with the microscope slide and the inspection of the specimen on the microscope slide is started. Alternatively, the immersion liquid can be arranged directly in between the objective lens and the microscope slide inside the vacuum chamber, contacting both the objective lens and the microscope slide. The immersion liquid is exposed to the vacuum inside the vacuum chamber during a set pretreatment time, and after this pretreatment time, the inspection of the specimen on the microscope slide is started.

According to yet further elaboration of the present invention, said immersion liquid is contained, i.e. applied in the apparatus, by a vacuum wall. In an embodiment said vacuum wall is arranged to circumvent and/or enclose the objective lens and the immersion liquid, which vacuum wall extends towards the microscope slide. Such a vacuum wall within the vacuum space defines a confined space around said immersion liquid, such that evaporation and outgassing is strongly limited through an increased local vapour pressure in said confined space. The increased local vapour pressure in said confined space is preferably obtained due to the little chance of escape of vapour out of said confined space. In an embodiment the vacuum wall is arranged at a distance to said microscope slide, preferably leaving a narrow slit between said vacuum wall and the microscope slide.

Also, as a further elaboration of a particular embodiment of the present invention, the vacuum wall circumventing the objective lens and the immersion liquid is included as an elastically deformable wall, allowing at least some adjustment of focus and movement in a plane transverse to an optical axis of the electron and/or optical microscope.

The apparatus according to the invention may further be provided with an extra container or supply container, preferably of variable size, containing more of said immersion liquid and which container has a connection to the immersion liquid between the objective lens and the microscope slide. With this measure said container may supply and replenish the immersion liquid in case of gradually proceeded evaporation and in case that the amount of liquid is reduced due to movement of the sample with respect to the objective lens. Thirdly and not unimportant said container may act as a dispenser to re-establish the liquid level.

The invention yet further includes that the microscope slide may be moved, in particular translated with respect to the objective lens of the optical microscope. In this aspect of the invention the effect and insight that immersion liquid will remain adhered to the sample is applied. It is recognized that this measure may for some, less stable liquids, i.e. liquids with a tendency to continue outgassing be it at a lower pace, result in that the vacuum threshold is passed or the immersion liquid is evaporated to an extend that said liquid is no longer filling the gap between the objective lens and the microscope slide, in particular after many translations of the sample. Yet, this feature may in a for practical purposes attractive number of other cases favorably be applied.

According to yet a further particular aspect of the present invention, the apparatus features the optical microscope mounted onto a door of the vacuum chamber of said apparatus. In particular the microscope is included in the apparatus by means of a mount affixed to the door of the apparatus, the door at least virtually forming a wall of the vacuum chamber of the apparatus. In this manner, easy and stable refill or re-application of immersion liquid and easy and safe cleaning of the lens may be accomplished.

It is remarked that the invention includes that the immersion liquid with refractive index larger than 1 may consists of a mixture between one or more vacuum compatible liquids and one or more not vacuum compatible liquids. This measure sets forth a different manner of attaining a immersion liquid of good refractive quality applicable in vacuum. Also, in this manner, it is foreseen that some immersion liquids optimized for use in atmospheric environment, which are less suited for the earlier mentioned out gassing treatment may still be applied for the present purpose with reasonable if not good satisfaction.

In the apparatus according to the invention, the microscope may be a confocal microscope or another type of optical microscope for which the use of an immersion liquid is beneficial. It is also remarked that the measures according to the present invention may equally be applied, or in fact may be applied to any fluorescence or cathodoluminescent based microscopy system. The present invention is in particular also applicable in case of an environmental scanning electron microscope (ESEM), in which water vapor is released into the vacuum chamber, so that the pressure is somewhat increased be it still well below atmospheric pressure. In such systems immersion liquids, such as immersion oils, can be applied that would otherwise not qualify for reason that the threshold value for outgassing as applicable in most common systems is not met, but which may well still qualify for a vacuum threshold value as applicable in an ESEM.

In the apparatus according to the invention, the optical and the electron microscope preferably are included aligned with respect to each other, i.e. the specimen may simultaneously be inspected by each of the electron and the optical microscope.

The present invention is furthermore equally applicable in combination with an environmental cell, which may be described as a liquid enclosure, with which a sample may be held in water within the vacuum chamber of the combined microscope. Such a cell or enclosure has an electron transparent window at the top, at least at the electron microscope side, and is optically transparent at the opposite, e.g. bottom side. In this situation the immersion liquid, in particular an immersion oil, should be optically compatible for use with water. Hence the immersion liquid according to the present invention will in such case furthermore be provided, at least will show a refractive index equal to, at least corresponding to that of water. One example of such an application comprises outgassed Immersol W®. It may be clear that within the scope of the present invention, the microscope slide may be the bottom side of the environmental cell.

Finally it is remarked, by way of further example and confirmation, that the present invention may equally be applied in solid immersion lens systems, i.e. in which the fluid according to the invention is applied in between two slides.

### BRIEF DESCRIPTION OF THE DRAWINGS

Various aspects of the invention and certain examples of embodiments of the invention are illustrated in the drawings in which:
FIGURE 1 schematically depicts a basic design of an apparatus as typically improved by the present invention;
FIGURE 2 provides a schematic design in accordance with the present invention wherein light optics compatible liquid is introduced in vacuum condition directly in between objective lens and substrate slide;
FIGURE 3 schematically represents a system in according to further elaboration of the invention, provided with a vacuum wall; and
FIGURE 4 schematically represents yet another elaboration of the present invention, wherein the microscope system is provided with an optional immersion cell as well as with an optional reservoir comprising liquid dispenser system.

### DESCRIPTION OF ILLUSTRATIVE EMBODIMENTS

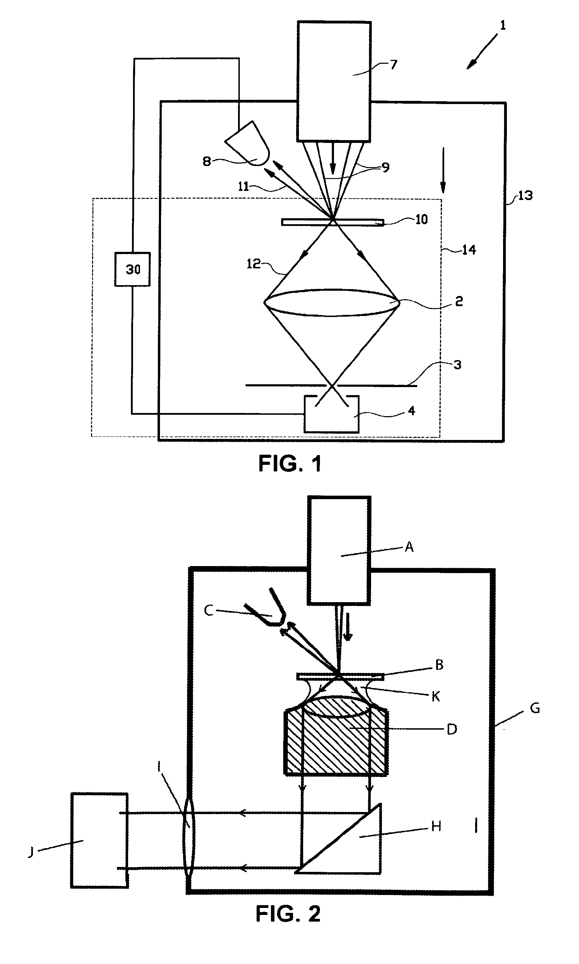

By way of exemplifying a typical context of the present invention, a principle and relatively simple set up of a so-called optical SEM combination as known from the prior art will be provided. This example however by no means excludes any known or yet unknown variation or alternative thereof. Hence, with reference first to figure 1, the basic design of such an inspection apparatus 1 of the invention is explained. It comprises in combination at least an optical microscope 2, 3, 4 and a charged particle such as an ion- or electron microscope 7, 8 equipped with a source 7 for emitting a primary beam 9 of radiation to a sample 10 in a sample holder. The apparatus may comprise a detector 8 for detection of secondary radiation 11 backscattered from the sample 10, or emitted, transmitted, or scattered from the sample 10 and possibly induced by the primary beam 9. The optical microscope 2, 3, 4 is equipped with an light collecting device 2 to receive in use luminescence light 12 emitted by the sample 10 and induced by the primary beam 9 of radiation and to focus it on a photon-detector 4. The light collecting device may also be used to focus light on the sample or to collect light that is induced by light incident on the sample, such as fluorescence. The light collecting device 2 may be an objective, a mirror or a glass fiber. It may also consist of a plurality of devices to arrange for collecting and focusing of the concerning luminescence light 12 that is emitted by the sample 10, e.g. using a known per se CCD camera. In the present example the optical microscope 2, 3, 4 is of the confocal type having a pinhole 3 between the objective 2 and the photon-detector 4. In this embodiment the optical microscope 2, 3, 4 is placed entirely inside the vacuum chamber 13 of the ion- or electron microscope 7, 8. The closed dashed line 14 encircles those parts of the inspection apparatus 1 of the invention that may all or some of them be mounted on the (replaceable) door of the vacuum chamber 13, notably the sample holder for the sample 10, the light collecting device 2, the pinhole 3, and the photon-detector 4. This particular construction enables an easy retrofit or completion of an existing charged particle microscope according to prior art in order to convert it into an inspection apparatus according of the integrated type as is subject to the present invention.

In figure 1, a processing unit 30, alternatively denoted controller is provided in simplified form, however known per se and useable as an automation unit, e.g. in the form of a computer, including personal computer provided with dedicated software, implementing one or more methods of use of the inspection apparatus. The controller 30 may typically be provided with one or more screens, e.g. one screen or screen part for depicting the recorded optical image, and the other or another part of the same screen depicting an image, in particular of the same object, i.e. substrate, recorded via the charged particle part of the inspection apparatus. Each of these images are in the known inspection apparatuses provided with their own coordinate system. In the known inspection apparatuses, e.g. as described above, the primary beam may influence the luminescence light, emitted by a marker in the sample. It may be the case that the primary beam destroys the marker, thereby preventing the marker from emitting luminescence light. This may generally be the case with organic fluorophores or other molecular light emitting markers. A marker may also be used that responds differently to the primary beam. For example, markers may comprise semiconductor nanocrystals (SNC), or so-called quantum dots (QD). SNC are tiny inorganic crystalline particles, while most QD are particles containing an inorganic crystalline core surrounded by one or multiple inorganic or organic shells of a different material or composition. It may also generally be the case that the primary beam changes the environment, e.g. the substrate, of the marker, which leads to the marker emitting more or less light, i.e. appearing brighter or dimmer in the image. In the following alternative methods are proposed of correlating the "charged particle image", i.e. image developed, i,e. generated by the processing unit and the charged particle part of the apparatus, to the "optical image", i.e. the image developed, i.e. generated by the processing unit and the optical part of the apparatus.

### Improved Optical SEM inspection apparatus

Figure 2 depicts an apparatus in accordance with the concept illustrated along figure 1, showing known per se components including a vacuum chamber G, (13 in fig. 1), a charged particle beam column A (7 in fig. 1), a sample B (10 in fig. 1), a charged particle detector C (8 in fig. 1), an objective lens D (2 in fig. 1), a mirror H, an optical window I, an optical excitation and detection unit J, the latter three not indicated in figure 1 and an immersion fluid in the form of liquid K, providing a novel arrangement over the prior art in accordance with figure 1. The immersion liquid K typically is a non vacuum compatible immersion oil as known from and optimized for in air use, i.e. atmospheric conditions, selected from a group comprising but not restricted to Zeiss Immersol W and Cargille Type OVH.

Typically the refractive index for such immersion liquids matches, i.e. is in general optimized for the optical lens and the slide, which includes that it does not show fluorescence. In practice many types of liquid immersion liquids, generally an immersion oil, is supplied by a manufacturer of optical microscopes, hence providing certainty with respect to optical matching to their system. Such immersion oils may e.g. also be adapted for any use of water at the upper side of the slide. Normally, if not in all cases, these immersion liquids are not suited for use in vacuum.

Immersion liquids that are specified for vacuum conditions in most cases do not match the optical requirements or specifications of the optical system as now applied in vacuum. For instance so called ionic liquids are available as immersion liquids for use in vacuum, however these are not optimized for other features.

In the solution according to the present invention, reputed immersion oils for non-vacuum application are taken as a basis for achieving vacuum as well as optically compatible liquid, i.e. for direct use between the optical lens and slide, by pre-treating these well known oils in the form of exposure thereof to vacuum. This exposure incites so called out gassing of the liquid. Such out gassing is performed up to a threshold at which the flux of outgoing gas is sufficiently low not to cause deterioration of vacuum or lens at actual use of the outgassed liquid.

At some liquids that may be selected for the procedure of outgassing and direct use in vacuum, outgassing continues to the extend that the liquid is determined not fit for use in vacuum. In other cases however, outgassing flux drops to a relatively low level, such that the latter can, in accordance with a further measure in accordance with the invention, be contained, in fact minimized further, by applying the liquid in a virtually concealed environment within vacuum. Hence the invention encompasses the application of a wall, preferably relatively closely circumventing the objective lens and leaving only a narrow slit connecting to vacuum, between the wall and the slide. Preferably such wall is elastically deformable, so that focal adjustment as well as relative movement with respect to the slide can be made, i.e. within a plane parallel to the slide, or transverse to the optical axis of the objective lens.

A pre-treatment procedure as mentioned before, is for each commercial fluid calibrated once beforehand using a spectrum analyser, thus determining that certain components of the liquid have come below a certain level. These components generally constitute fractions of volatile components, not necessarily known, and may be present in dependence of causes like type of immersion liquid or oil used, components applied thereto and manufacturing process.

In combination with the insight that the surface over which the immersion liquid would be applied, it was decided and conceived that known immersion liquids optimized for optical microscopy, could be used in vacuum directly between objective lens and slide if they would have been out-gassed in advance. Elastically deformable walls as described above may be provided for use around the objective lens for use of immersion liquids that may not fully stop outgassing.

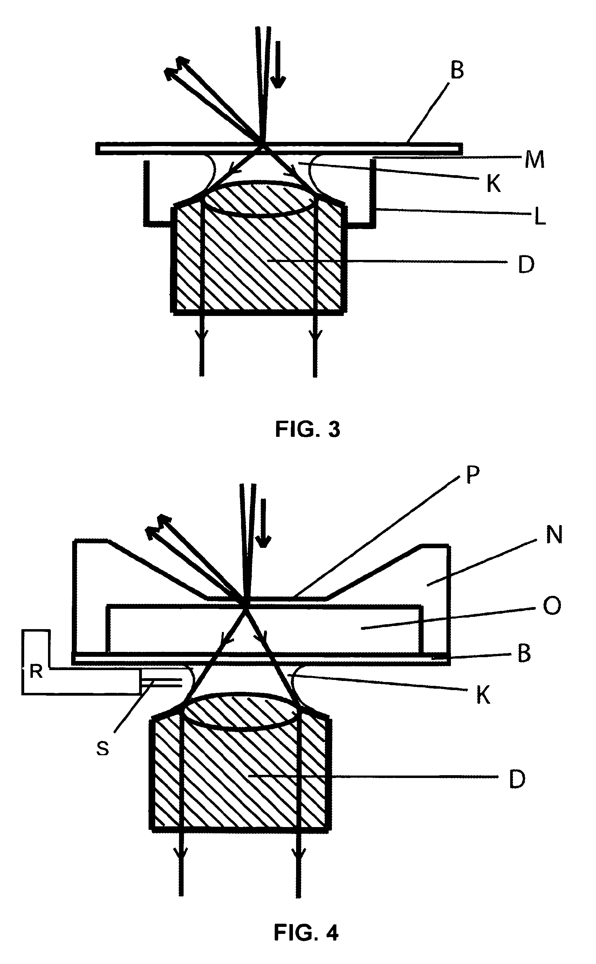

Figure 3 illustrates an optional feature and elaboration in conjunction with the present invention, according to which the immersion liquid K between optical lens D and sample slide B is surrounded by a vacuum wall L alternatively denote container, creating a spatial enclosure thereof, thereby containing outgassings and vapors from said immersion liquid K within the space inside said vacuum wall L. In the present example the wall extends from the optical lens D upwards to the slide B, well within the perimeters thereof, leaving a narrow slit M between the slide B and an edge part of the wall L. By this measure, vapor pressure in the space inside said vacuum wall L may locally rise without or hardly disturbing the vacuum space of the vacuum chamber G (as shown in figure 2) and with the effect that outgassing of the immersion liquid K may be reduced or balanced due to the locally higher vapor pressure.

Comparably figure 4 sets forth two further optional features and elaborations of the present invention in that it depicts in the same figure both the application of a so-called environmental cell O, and the application of an immersion liquid dispenser system with preferably vacuum included reservoir R. The latter system may be provided with a manually or electronically controlled pumping system in combination with a preferably retractable needle S extending from reservoir R to the space between the optical lens D and the microscope slide B.

Finally, the environment cell as illustrated along figure 4 comprises an enclosure N, a liquid, normally water, environment O with a sample. The enclosure N comprises an electron transparent membrane P, and an optical transparent window which in an example is a microscope slide B.

## Claims

1. Apparatus for inspecting a sample, said apparatus equipped with a charged particle column (A) for producing a focused beam of charged particles to observe or modify the sample, an optical microscope (2, 3, 4) to observe the sample through a microscope slide (B), a vacuum chamber (G) that contains the microscope slide (B) and at least the objective lens (D) of the optical microscope, wherein a liquid (K) is included between the objective lens (D) of the microscope and the microscope slide (B), directly in between objective lens (D) and microscope slide (B), to at least substantially fill the space between the objective lens (B) of the microscope and the microscope slide (B).

2. Apparatus according to claim 1, wherein the liquid may be of none vacuum compatible origin, said liquid included after having been pretreated by exposure of the liquid in a vacuated chamber.

3. The apparatus according to claim 1 or 2, in which said liquid has been pretreated by storing it in a vacuated chamber until out gassing of said liquid has decreased below a certain threshold.

4. The apparatus according to claim 2 or 3, in which the pretreatment of the liquid is performed within the vacuum chamber of the charged particle beam apparatus.

5. The apparatus according to any one of the preceding claims, in which said liquid is an immersion oil for fluorescence microscopy

6. The apparatus according to any one of the preceding claims, in which said liquid is contained by a vacuum wall leaving a narrow slit between said wall and the microscope slide, preferably in which the vacuum wall circumventing the objective lens and the immersion liquid is included as an elastically deformable wall, allowing at least some adjustment of focus and movement in a plane transverse to an optical axis.

7. The apparatus according to any one of the preceding claims, in which a supply container is provided which contains more of said liquid and has a connection to the liquid between the objective lens and the microscope slide.

8. The apparatus according to any one of the preceding claims, in which the microscope slide can be translated with respect to the objective lens of the optical microscope

9. The apparatus according to any one of the preceding claims, in which the fluid with refractive index larger than 1 consists of a mixture between one or more vacuum compatible liquids and one or more not vacuum compatible liquids.

10. The apparatus according to any one of the preceding claims, in which the microscope is included in the apparatus by means of a mount affixed to a door of the apparatus, the door at least virtually forming a wall of the vacuum chamber of the apparatus.

11. The apparatus according to any one of the preceding claims, in which the microscope is a confocal microscope, or in which the apparatus is adapted for fluorescence microscopy, cathodoluminescence detecting microscopy, or environmental scanning electron microscopy (ESEM).

12. The apparatus according to any one of the preceding claims, wherein the charged particle column for producing a focused beam of charged particles to observe or modify the sample is part of an electron microscope, wherein the optical microscope and the electron microscope are aligned.

13. The apparatus according to any one of the preceding claims, in which the microscope slide is the bottom side of an environmental cell, and/or in which the liquid is included in between two slides.

14. Method of operating an apparatus for inspecting a sample, said apparatus equipped with a charged particle column (A) for producing a focused beam of charged particles to observe or modify the sample, an optical microscope to observe the sample through a microscope slide, a vacuum chamber (G) that contains the microscope slide (B) and at least the objective lens (D) of the optical microscope, wherein upon operation of the apparatus a liquid (K) is introduced directly onto the objective lens (D) of the microscope to at least substantially fill the space between the objective lens (D) of the microscope and the microscope slide (B).

15. Method of operating an apparatus for inspecting a sample according to claim 14, wherein said liquid has been out-gassed in advance.

## Patentansprüche

1. Apparat zum Untersuchen einer Probe, welcher Apparat ausgerüstet ist mit einer Ladungsteilchensäule (A) zum Erzeugen eines fokussierten Strahls von geladenen Teilchen zum Beobachten oder Modifizieren der Probe, einem optischen Mikroskop (2, 3, 4) zum Beobachten der Probe durch einen Objektträger (B), einer Vakuumkammer (6), welche den Objektträger (B) und wenigstens die Objektivlinse (D) des optischen Mikroskops enthält, wobei eine Flüssigkeit (K) enthalten ist zwischen der Objektivlinse (D) des Mikroskops und dem Objektträger (B), direkt zwischen der Objektivlinse (D) und dem Objektträger (B), um den Raum zwischen der Objektivlinse (D) des Mikroskops und dem Objektträger (B) wenigstens im Wesentlichen zu füllen.

2. Apparat nach Anspruch 1, bei welchem die Flüssigkeit von nichtvakuumkompatibler Herkunft sein kann, wobei die Flüssigkeit enthalten ist, nachdem sie durch Exposition in einer evakuierten Kammer vorbehandelt worden ist.

3. Apparat nach Anspruch 1 oder 2, bei welchem die Flüssigkeit vorbehandelt worden ist durch Lagern in einer evakuierten Kammer bis das Ausgasen der Flüssigkeit unter eine bestimmte Schwelle gefallen ist.

4. Apparat nach Anspruch 2 oder 3, bei welchem die Vorbehandlung der Flüssigkeit innerhalb der Vakuumkammer der Ladungsteilchenapparatur erfolgt.

5. Apparat nach einem der vorhergehenden Ansprüche, bei welchem die Flüssigkeit ein Immersionsöl für Fluoreszenzmikroskopie ist.

6. Apparat nach einem der vorhergehenden Ansprüche, bei welchem die Flüssigkeit von einer Vakuumwand umgrenzt ist, welche einen schmalen Schlitz lässt zwischen der Wand und dem Objektträger, vorzugweise bei welchem die Vakuumwand, welche die Objektivlinse und die Immersionsflüssigkeit umgibt, als eine elastisch deformierbare Wand enthalten ist, die wenigstens eine geringfügige Anpassung des Fokus und Bewegung in einer Ebene quer zur optischen Achse erlaubt.

7. Apparat nach einem der vorhergehenden Ansprüche, bei welchem ein Versorgungsbehälter bereitgestellt ist, der mehr von der Flüssigkeit enthält und eine Verbindung zu der Flüssigkeit zwischen der Objektivlinse und dem Objektträger hat.

8. Apparat nach einem der vorhergehenden Ansprüche, bei welchem der Objektträger relativ zur Objektivlinse des optischen Mikroskops bewegt werden kann.

9. Apparat nach einem der vorhergehenden Ansprüche, bei welchem das Fluid mit Brechungsindex größer als 1 besteht aus einer Mischung zwischen einem oder mehreren vakuumkompatiblen Flüssigkeiten und einem oder mehreren nichtvakuumkompatiblen Flüssigkeiten.

10. Apparat nach einem der vorhergehenden Ansprüche, bei welchem das Mikroskop in dem Apparat enthalten ist mittels einer Halterung, die an einer Tür des Apparats befestigt ist, wobei die Tür wenigstens faktisch eine Wand der Vakuumkammer des Apparats bildet.

11. Apparat nach einem der vorhergehenden Ansprüche, bei welchem das Mikroskop ein konfokales Mikroskop ist, oder bei welchem der Apparat geeignet ist für Fluoreszenzmikroskopie, Kathodenlumineszenzdetektionsmikroskopie oder Umfeldscanningelektronenmikroskopie (ESEM).

12. Apparat nach einem der vorhergehenden Ansprüche, bei welchem die Ladungsteilchensäule zum Produzieren eines fokussierten Strahls von geladenen Teilchen zum Beobachten oder Modifizieren der Probe ein Teil eines Elektronenmikroskops ist, wobei das optische Mikroskop und das Elektronenmikroskop ausgerichtet sind.

13. Apparat nach einem der vorhergehenden Ansprüche, bei welchem der Objektträger die Bodenseite einer Umfeldzelle ist, und/oder bei welchem die Flüssigkeit zwischen zwei Trägern enthalten ist.

14. Verfahren zum Betreiben eines Apparats zum Untersuchen einer Probe, wobei der Apparat ausgerüstet ist mit einer Ladungsteilchensäule (A) zum Erzeugen eines fokussierten Strahls von geladenen Teilchen zum Beobachten oder Modifizieren der Probe, einem optischen Mikroskop zum Beobachten der Probe durch einen Objektträger, eine Vakuumkammer (G), welche den Objektträger (B) und wenigstens die Objektivlinse (D) des optischen Mikroskops enthält, wobei bei Betreiben des Apparats eine Flüssigkeit (K) direkt auf die Objektivlinse (D) des Mikroskops eingebracht wird, um den Raum zwischen der Objektivlinse (D) des Mikroskops und dem Objektträger (B) wenigstens im Wesentlichen zu füllen.

15. Verfahren zum Betreiben eines Apparats zum Untersuchen einer Probe nach Anspruch 14, bei welchem die Flüssigkeit vorher ausgegast wurde.

## Revendications

1. Appareil d'examen d'un échantillon, ledit appareil étant équipé d'une colonne de particules chargées (A) pour produire un faisceau focalisé de particules chargées pour observer ou modifier l'échantillon, d'un microscope optique (2, 3, 4) pour observer l'échantillon à travers une lame de microscope (B), d'une chambre à vide (G) qui contient la lame de microscope (B) et au moins la lentille de focalisation (D) du microscope optique, dans lequel un liquide (K) est inclus entre la lentille de focalisation (D) du microscope et la lame de microscope (B), directement entre la lentille de focalisation (D) et la lame de microscope (B), pour remplir au moins sensiblement l'espace entre la lentille de focalisation (D) du microscope et la lame de microscope (B).

2. Appareil selon la revendication 1, dans lequel le liquide peut être d'aucune origine compatible avec le vide, ledit liquide étant inclus après avoir été prétraité par exposition du liquide dans une chambre à vide.

3. Appareil selon la revendication 1 ou 2, dans lequel ledit liquide a été prétraité en le stockant dans une chambre à vide jusqu'à ce qu'un dégazement dudit liquide soit descendu en dessous d'un certain seuil.

4. Appareil selon la revendication 2 ou 3, dans lequel le prétraitement du liquide est réalisé dans la chambre à vide de l'appareil à faisceau de particules chargées.

5. Appareil selon l'une quelconque des revendications précédentes, dans lequel ledit liquide est une huile à immersion pour microscopie par fluorescence.

6. Appareil selon l'une quelconque des revendications précédentes, dans lequel ledit liquide est contenu par une paroi à vide laissant une fente étroite entre ladite paroi et la lame de microscope, de préférence dans lequel la paroi à vide contournant la lentille de focalisation et le liquide à immersion est inclus en tant que paroi déformable élastiquement, permettant au moins un certain réglage de mise au point et de déplacement dans un plan transversal à un axe optique.

7. Appareil selon l'une quelconque des revendications précédentes, dans lequel un contenant d'alimentation est prévu qui contient davantage dudit liquide et a un lien avec le liquide entre la lentille de focalisation et la lame de microscope.

8. Appareil selon l'une quelconque des revendications précédentes, dans lequel la lame de microscope peut être translatée par rapport à la lentille de focalisation du microscope optique.

9. Appareil selon l'une quelconque des revendications précédentes, dans lequel le fluide avec un indice de réfraction supérieur à 1 est constitué d'un mélange entre un ou plusieurs liquides compatibles avec le vide et un ou plusieurs liquides non compatibles avec le vide.

10. Appareil selon l'une quelconque des revendications précédentes, dans lequel le microscope est inclus dans l'appareil au moyen d'un support apposé à une porte de l'appareil, la porte formant au moins pratiquement une paroi de la chambre à vide de l'appareil.

11. Appareil selon l'une quelconque des revendications précédentes, dans lequel le microscope est un microscope confocal, ou dans lequel l'appareil est adapté pour une microscopie par fluorescence, une microscopie de détection par cathodoluminescence, ou une microscopie électronique à balayage environnemental (MEBE).

12. Appareil selon l'une quelconque des revendications précédentes, dans lequel la colonne de particules chargées pour produire un faisceau focalisé de particules chargées pour observer ou modifier l'échantillon fait partie d'un microscope électronique, dans lequel le microscope optique et le microscope électronique sont alignés.

13. Appareil selon l'une quelconque des revendications précédentes, dans lequel la lame de microscope est le côté de fond d'une cellule environnementale, et/ou dans lequel le liquide est inclus entre deux lames.

14. Procédé de fonctionnement d'un appareil d'examen d'un échantillon, ledit appareil étant équipé d'une colonne de particules chargées (A) pour produire un faisceau focalisé de particules chargées pour observer ou modifier l'échantillon, d'un microscope optique pour observer l'échantillon à travers une lame de microscope, d'une chambre à vide (G) qui contient la lame de microscope (B) et au moins la lentille de focalisation (D) du microscope optique, dans lequel lors du fonctionnement de l'appareil, un liquide (K) est introduit directement sur la lentille de focalisation (D) du microscope pour remplir au moins sensiblement l'espace entre la lentille de focalisation (D) du microscope et la lame de microscope (B).

15. Procédé de fonctionnement d'un appareil d'examen d'un échantillon selon la revendication 14, dans lequel ledit liquide a été dégazé à l'avance.
